# EUROPEAN PATENT APPLICATION

(11) **EP 3 115 812 A1**
(43) Date of publication of application: **11.01.2017**
(21) Application number: 15757976.4
(22) Date of filing: 26.02.2015
(51) Int. Cl.: G02B 5/26, B32B 9/00, C23C 14/06, C23C 14/34

(54) **INFRARED REFLECTING SUBSTRATE AND METHOD FOR PRODUCING SAME**

(30) Priority: 03.03.2014 JP 2014040906
(71) Applicant: Nitto Denko Corporation, Ibaraki-shi, Osaka 567-8680 (JP)
(72) Inventor: WATANABE, Masahiko, Ibaraki-shi Osaka 567-8680 (JP); OHMORI, Yutaka, Ibaraki-shi Osaka 567-8680 (JP)
(74) Representative: Gill Jennings & Every LLP
(86) International application number: PCT/JP2015/055702
(87) International publication number: WO 2015/133370

(57) **Abstract**

The infrared reflecting substrate (100) includes a first metal oxide layer (21), a second metal oxide layer (22) and a metal layer (30) in this order on a transparent substrate (10). The second metal oxide layer (22) and the metal layer (30) are in direct contact with each other. The first metal oxide layer (21) has a refractive index of 2.2 or more. It is preferable that the second metal oxide layer (22) is formed of a metal oxide that contains tin oxide and zinc oxide, and an oxygen content of the metal oxide is less than the stoichiometric composition. The second metal oxide layer is preferably deposited by a DC sputtering method. A target which contains zinc atoms and tin atoms and is obtained by sintering a metal powder and at least one metal oxide among zinc oxide and tin oxide is preferably used for deposition of the second metal oxide layer. It is preferable that the oxygen concentration in a gas introduced into a sputtering chamber is 8% by volume or less. An infrared reflecting substrate having a high visible light transmittance and excellent durability can be provided by the present invention.

## Description

### TECHNICAL FIELD

The present invention relates to an infrared reflecting substrate that can exert heat shielding properties and heat insulating properties by reflecting infrared rays, and a method for producing the same.

### BACKGROUND ART

An infrared reflecting substrate in which an infrared reflecting layer is provided on a transparent substrate of glass, film or the like is used for the purpose of imparting heat shielding properties and heat insulating properties to window glass, store windows or the like. The infrared reflecting layer preferably has a high reflectance of the infrared rays and a low emissivity, and a metal such as silver is used as a material of the infrared reflecting layer.

When the infrared reflecting substrate is applied to window glasses or the like, it is required that a visible light transmittance is high. Since a metal layer, such as a silver layer, has a high visible light reflectance and low transparency, it is necessary to improve the wavelength selectivity of transmittance and reflectance of the infrared reflecting layer to reduce the visible light reflectance in order to increase a visible light transmittance of the infrared reflecting substrate. Therefore, a metal layer such as a silver layer and a metal oxide layer such as an indium-tin oxide (ITO) are stacked to exert multiplex interference effect of reflected light, so that desired wavelength selectivity of a transmittance and a reflectance is imparted to the infrared reflecting substrate.

Patent Document 1 proposes using a high-refractive index material such as titanium dioxide (TiO₂) as a metal oxide layer to increase a visible light transmittance. Further, Patent Document 1 discloses a method in which the titanium oxide layer is deposited on a metal layer such as a silver layer by a DC sputtering method with using a reductive oxide target (target having an oxygen content less than that of an oxide having stoichiometric composition) that is obtained from a mixture of a titanium oxide powder and a metal titanium powder. It is disclosed that according to this method, not only a metal oxide can be deposited at high rate, but also oxidation of the metal layer is suppressed, thereby an infrared reflecting substrate having a high visible light transmittance and a low emissivity (high heat insulating properties) is obtained.

Patent Document 2 discloses that a transparent conductive film including zinc-tin oxide (ZTO) on both sides of a silver layer is used for an electromagnetic shielding filter of a plasma display and a transparent electrode of a liquid crystal display. Since the ZTO has excellent humidity resistance or chemical resistance, the durability of the transparent conductive film is enhanced. As a deposition method of the ZTO layer, Patent Document 2 discloses a sputtering method using an oxide sintered body target of Zn and Sn, and a reactive sputtering method of using a metal target, and the method of using the oxide sintered body target is preferred from the viewpoint of reducing the damages to a metal film.

Further, Patent Document 2 discloses disposing another metal oxide layer on the ZTO film to enhance electrical conductivity or chemical resistance, for the purpose of improving mechanical durability and chemical durability of a transparent conductive film. It is also described that the visible light anti-reflection properties are enhanced to improve transparency by using a high-refractive index material such as titanium dioxide as a metal oxide layer formed on the ZTO film.

### PRIOR ART DOCUMENTS

### PATENT DOCUMENTS

Patent Document 1: JP 11-124689 A
Patent Document 2: JP 2007-250430 A

### SUMMARY OF THE INVENTION

### PROBLEMS TO BE SOLVED BY THE INVENTION

As disclosed in Patent Documents 1 and 2, the visible light reflectance can be reduced to enhance transparency by a stacking configuration of a metal layer such as a silver layer and a high-refractive index metal oxide layer such as a titanium oxide layer. However, a high-refractive index metal oxide such as a titanium dioxide has poor adhesion to the metal layer such as a silver layer. Therefore, the infrared reflecting substrate disclosed in Patent Document 1 is low in durability and has a problem that the transparency and infrared reflecting properties (heat insulating properties and heat shielding properties) are deteriorated due to degradation of the metal layer. Further, when a completely oxidized ZTO layer is disposed between a metal layer and a high-refractive index metal oxide layer as disclosed in Patent Document 2, an adhesion between the metal layer and the ZTO layer is insufficient, and a significant improvement of durability could not be expected.

Further, when the ZTO layer is formed by a reactive sputtering method using a metal target composed of a metal zinc and a metal tin as disclosed in Patent Document 2, a metal layer (Ag, etc.) serving as an underlay for deposition of ZTO is oxidized by excessive oxygen in a deposition atmosphere, and thus characteristics, such as heat shielding properties, heat insulating properties and transparency (visible light transmittance) of the infrared reflecting substrate, are deteriorated. On the other hand, an oxide sintered body target of zinc oxide and tin oxide has low electrical conductivity. Particularly, when an Sn-rich ZTO having high tin content is used, it is difficult to stably perform a deposition by a DC sputtering method, which is in general capable of realizing a high deposition rate.

As described above, in an infrared reflecting substrate including a stacked body of a metal layer and a metal oxide layer on the transparent substrate, a reflection of visible light can be reduced to improve transparency by using a high-refractive index metal oxide layer, but it has been difficult to impart desired durability. Further, even when the ZTO is disposed between the metal layer and the high-refractive index metal oxide layer, effective means of improving the productivity and increasing the adhesion to the metal layer has not been found out in conventional methods.

### MEANS FOR SOLVING THE PROBLEMS

In view of the above-mentioned situations, the inventors made investigations, and consequently found that when a ZTO is deposited between a high-refractive index metal oxide layer and a metal layer by sputtering with using a target obtained by sintering a metal oxide and a metal powder, adhesion between layers is increased to obtain an infrared reflecting substrate having a high visible light transmittance and excellent durability, in addition that a high deposition rate is realized.

The infrared reflecting substrate of the present invention includes, on a transparent substrate, a first metal oxide layer, a second metal oxide layer and a metal layer in this order, and the second metal oxide layer and the metal layer are in direct contact with each other. In one embodiment of the present invention, the transparent substrate is a flexible transparent film.

The first metal oxide layer has a refractive index of 2.2 or more. The first metal oxide layer is preferably formed of an oxide of one or more metals selected from the group consisting of Ti, Nb, Ta, Mo, W and Zr. The second metal oxide layer is formed of a metal oxide that contains tin oxide and zinc oxide and has an oxygen content that is less than the stoichiometric composition.

In a preferred embodiment of the present invention, the infrared reflecting substrate further includes a surface-side metal oxide layer on the surface of the metal layer on the side opposite to the substrate-side. The surface-side metal oxide layer is preferably in direct contact with the metal layer. As a material of the surface-side metal oxide layer, a metal oxide containing tin oxide and zinc oxide is preferably used.

In a more preferred embodiment of the present invention, the infrared reflecting substrate includes a transparent resin layer on the surface-side metal oxide layer. The transparent resin layer is preferably in direct contact with the surface-side metal oxide layer. The thickness of the transparent resin layer is preferably 20 nm to 150 nm.

The present invention also relates to a method for producing an infrared reflecting substrate including a first metal oxide layer, a second metal oxide layer and a metal layer in this order on a transparent substrate. The production method of the present invention includes, in the order: a step of depositing a first metal oxide layer on a transparent substrate (first metal oxide layer forming step); a step of depositing a second metal oxide layer by a DC sputtering method on the first metal oxide layer (second metal oxide layer forming step); and a step of depositing a metal layer immediately on the second metal oxide layer (metal layer forming step).

In the production method of the present invention, as a sputtering target for the second metal oxide layer forming step, a target containing zinc atoms and tin atoms and obtained by sintering a metal powder and at least one metal oxide among zinc oxide and tin oxide is used. An inert gas and oxygen are introduced into a sputtering chamber in deposition of the second metal oxide layer. The oxygen concentration in the gas introduced into the sputtering chamber is preferably 8 vol% or less.

In the production method of the present invention, a step of forming a surface-side metal oxide layer on the metal layer (surface-side metal oxide layer forming step) may be performed after the metal layer forming step. In the surface-side metal oxide layer forming step, the surface-side metal oxide layer is preferably deposited by DC sputtering. In deposition of the second metal oxide layer by sputtering, a sputtering target containing zinc atoms and tin atoms and obtained by sintering a metal powder and at least one metal oxide among zinc oxide and tin oxide is preferably used.

The production method of the present invention may include, after forming the surface-side metal oxide layer, a step of further forming a transparent resin layer on the surface-side metal oxide layer (transparent resin layer forming step).

### EFFECTS OF THE INVENTION

Since the infrared reflecting substrate includes, between a transparent substrate and a metal layer, a first metal oxide layer having a high refractive index and a second metal oxide layer having specific composition, the infrared reflecting substrate of the present invention has a low visible light reflectance and an excellent transparency, and has high adhesion between the metal oxide layer and the metal layer thereby realizing excellent durability.

### BRIEF DESCRIPTION OF THE DRAWINGS

FIG. 1 is a cross-sectional view schematically showing a stacking configuration of an infrared reflecting substrate of one embodiment.
FIG. 2 is a cross-sectional view schematically showing a usage example of an infrared reflecting substrate.

### MODE FOR CARRYING OUT THE INVENTION

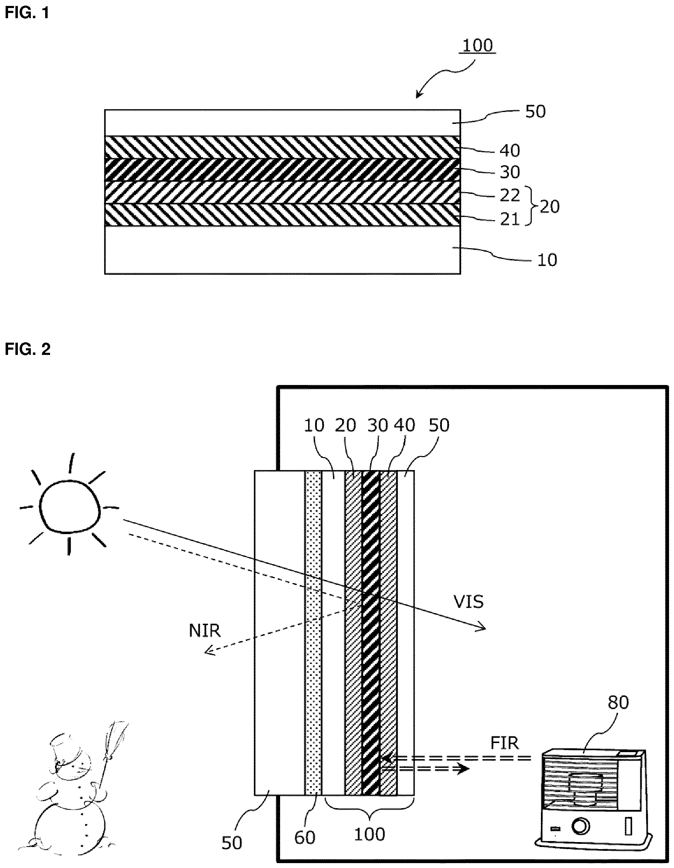

FIG. 1 is a cross-sectional view schematically showing a constituent example of an infrared reflecting substrate. An infrared reflecting substrate 100 includes a substrate-side metal oxide layer 20 and a metal layer 30 in this order on one principal surface of a transparent substrate 10. The substrate-side metal oxide layer 20 includes a first metal oxide layer 21 and a second metal oxide layer 22 in this order from the transparent substrate 10. The second metal oxide layer 22 and the metal layer 30 are in direct contact with each other.

### [Transparent Substrate]

As the transparent substrate 10, one having a visible light transmittance of 80% or more is suitably used. The visible light transmittance is measured according to JIS A 5759-2008 (Adhesive films for glazings).

The thickness of the transparent substrate 10 is not particularly limited, and it is, for example, about 10 µm to 10 mm. As the transparent substrate, a glass plate, a flexible transparent resin film or the like is used. Particularly, from the viewpoint of increasing the productivity of the infrared reflecting substrate and facilitating execution in bonding the infrared reflecting substrate to window glasses or the like, the flexible transparent resin film is suitably used as the transparent substrate 10. When the transparent resin film is used as the transparent substrate, its thickness is preferably in the range of about 10 µm to 300 µm. Further, since there may be cases where high temperature processes are performed in formation of metal layer, metal oxide layer and the like on the transparent substrate 10, a resin material constituting the transparent resin film substrate preferably has excellent heat resistance. Examples of the resin material constituting the transparent resin film substrate include polyethylene terephthalate (PET), polyethylene naphthalate (PEN), polyether ether ketone (PEEK), polycarbonate (PC) and the like.

When the transparent substrate 10 is a transparent resin film, a film provided with a hard coat layer on the film surface is suitably used for the purpose of increasing mechanical strength of the infrared reflecting substrate. Further, when a hare coat layer is provided on the metal oxide layer 20-forming surface of the transparent substrate, abrasion-resistance of the metal layer, the metal oxide layer and the transparent resin layer formed thereon tends to be enhanced. The hard coat layer can be formed, for example, by a method in which a cured coating of an appropriate ultraviolet-curable resin, such as acryl-based resin or silicone-based resin, is provided for the transparent film substrate. The hard coat layer with high hardness is suitably used.

For the purpose of increasing the adhesion between the transparent substrate and the first metal oxide layer 21 formed thereon, the surface of the transparent substrate 10 may be subjected to a surface modification treatment such as corona treatment, plasma treatment, flame treatment, ozone treatment, primer treatment, glow treatment, saponification treatment, or treatment with a coupling agent.

### [Substrate-Side Metal Oxide Layer]

The substrate-side metal oxide layer 20 is formed on the transparent substrate 10. The substrate-side metal oxide layer 20 includes the first metal oxide layer 21 and the second metal oxide layer 22 in this order from the transparent substrate 10.

### <First Metal Oxide Layer>

The first metal oxide layer 21 has a refractive index of 2.2 or more. By including the first metal oxide layer 21 having a high refractive index, the visible light reflectance of the infrared reflecting substrate is reduced to enhance transparency. The refractive index in the present specification is a value measured at a wavelength of 550 nm, and is measured by a spectroscopic ellipsometer.

As a material of the first metal oxide layer, oxides of one or more metals selected from the group consisting of Ti, Nb, Ta, Mo, W and Zr are preferably used. Specific examples thereof include titanium dioxide (TiO₂), niobium pentoxide (Nb₂O₂), tantalum pentoxide (Ta₂O₅), tungsten trioxide (WO₃), molybdenum trioxide (MoO₃), zirconium dioxide (ZrO₂), and composite oxides thereof.

Although the method for depositing the first metal oxide layer 21 is not particularly limited, deposition by a dry process such as a sputtering method, a vacuum deposition method, a CVD method or an electron-beam deposition method is preferred. Among them, a DC sputtering method is particularly preferred. The sputtering method may be any of a sputtering method of using an oxide target and a reactive sputtering method of using a metal target. Further, deposition by sputtering may be performed using a metal oxide target (reductive oxide target) having an oxygen content less than that of the stoichiometric composition, while an inert gas such as Ar and oxygen are introduced. Since the reductive oxide target has electrical conductivity higher than that of a completely oxidized target containing stoichiometric oxygen and thus a DC sputtering deposition rate increases, the productivity of the infrared reflecting substrate can be improved.

The reductive oxide target can be prepared, for example, by treating by a high-pressure compression method, sintering or thermally spraying a metal oxide and a metal powder. Among them, a sintering method is preferably employed. For example, a reductive oxide target for depositing titanium oxide is obtained by sintering a mixture of a titania powder and a metal titanium powder. A reductive oxide target for forming niobium oxide can be obtained by sintering a mixture of a niobium pentoxide powder and a metal Nb powder.

The thickness of the first metal oxide layer 21 is appropriately set in consideration of a material and a thickness of the metal layer and another metal oxide layer so that the visible light reflectance of the infrared reflecting substrate can be reduced to enhance transparency. The thickness of the first metal oxide layer may be adjusted, for example, within the range of about 3 nm to 50 nm, preferably within the range of about 5 nm to 30 nm, and more preferably within the range of about 7 nm to 25 nm.

### <Second Metal Oxide Layer>

The second metal oxide layer 22 is formed on the first metal oxide layer 21. The second metal oxide layer 22 is made of a composite metal oxide containing zinc oxide and tin oxide. The second metal oxide layer is disposed for the purpose of reducing a reflection amount of visible light together with the first metal oxide layer to achieve high visible light transmittance and an infrared reflectance simultaneously. Further, the durability of the infrared reflecting substrate is enhanced by disposing the second metal oxide layer between the first metal oxide layer and the metal layer.

The second metal oxide layer 22 may be formed directly on the first metal oxide layer 21, or may be formed with another layer interposed therebetween. From the viewpoint of simplifying a stacking configuration of the infrared reflecting substrate to improve the productivity, the second metal oxide layer 22 is preferably formed directly on the first metal oxide layer 21.

Zinc-tin oxide (ZTO) is excellent in chemical stability (resistance to acid, alkali, chloride ions and the like). As the second metal oxide layer 22, a material having an oxygen content less than that of the stoichiometric composition (having oxygen deficiency) is preferred. In comparison with ZTO having the stoichiometric amount of oxygen (completely oxidized), ZTO having oxygen deficiency tends to be excellent in the adhesion to the metal layer such as silver layer. Therefore, when the second metal oxide layer 22 is disposed adjacent to the metal layer 30, degradation of the metal layer is suppressed to enhance the durability of the infrared reflecting substrate. On the other hand, when the oxygen deficiency in the metal oxide increases excessively, absorption of visible light by a metal oxide is increased, and transparency tends to deteriorate.

Preferably, the second metal oxide layer 22 is deposited by a DC sputtering method. Since a deposition rate of DC sputtering method is high, it is possible to improve the productivity of the infrared reflecting substrate. A target containing zinc atoms and tin atoms and obtained by sintering a metal powder and at least one metal oxide among zinc oxide and tin oxide is used as a sputtering target for depositing the second metal oxide layer by a DC sputtering method. Specifically, when a target forming material contains zinc oxide and does not contain tin oxide, a metal tin powder is contained in the target forming material. When the target forming material contains tin oxide and does not contain zinc oxide, a metal zinc powder is contained in the target forming material. When the target forming material contains both of zinc oxide and tin oxide, a metal powder in the target forming material may be a powder of metal other than metal zinc and metal tin; however, the target forming material preferably contains at least any one among metal zinc and metal tin, and particularly preferably contains metal zinc.

Since zinc oxide and tin oxide (particularly, tin oxide) have a low electrical conductivity, a completely oxidized ZTO target obtained by sintering only a metal oxide has a low electrical conductivity. When such a target is used for DC sputtering, there is a tendency that discharge does not occur or performing deposition stably for a long time is difficult. In the present invention, in contrast, the electrical conductivity of the target is improved to stabilize discharge during DC sputtering deposition by using a reductive oxide target obtained by sintering a metal oxide and a metal powder.

When the amount of a metal used for formation of the sputtering target is excessively small, sufficient electrical conductivity is not imparted to the target, and therefore deposition by DC sputtering may become unstable. On the other hand, when the content of a metal in the target is excessively high, the amount of a remaining metal unoxidized during the sputtering deposition or the amount of a metal oxide whose oxygen content is less than the stoichiometric composition is increased, so that the oxygen amount of the metal oxide layer becomes excessively insufficient with regard to the stoichiometric composition and thus the visible light transmittance tends to be decreased. Therefore, the amount of the metal used for formation of the sputtering target is preferably 0.1 to 20 wt%, more preferably 0.2 to 15 wt%, further preferably 0.5 to 13 wt%, and particularly preferably 1 to 12 wt% in the target forming material. Since the metal powder used in the target forming material is oxidized by sintering, a part of the metal powder may exist as a metal oxide in a sintered target.

A ratio between zinc atoms (Zn) and tin atoms (Sn), respectively contained in the sputtering target used for the deposition of the second metal oxide layer 22, is preferably in the range of Zn : Sn = 10 : 90 to 60 : 40 in terms of an atomic ratio. The ratio between Zn and Sn is more preferably in the range of 15 : 85 to 50 : 50, and further preferably in the range of 20 : 80 to 40 : 60. By setting the content of Zn to 10 atom% or more with respect to 100 atom% as a total of Sn and Zn, the electrical conductivity of the target is increased to enable the deposition by DC sputtering, and therefore the productivity of the infrared reflecting substrate can be further increased. From the viewpoint of improving deposition properties, volume resistivity of the target is preferably 1000 mΩ•cm or less, more preferably 500 mΩ•cm or less, further preferably 300 mΩ•cm or less, particularly preferably 150 mΩ•cm or less, and most preferably 100 mΩ•cm or less.

On the other hand, when the content of Zn is excessively high and the content of Sn is relatively low, the durability of the infrared reflecting substrate tends to decrease due to a reduction of the durability of the second metal oxide layer itself or a reduction of the adhesion between the second metal oxide layer and the metal layer. Therefore, the content of Zn atoms in the target is preferably 60 atom% or less, more preferably 50 atom% or less, and further preferably 40 atom% or less with respect to 100 atom% as a total of Sn and Zn. Zinc atoms contained in the sputtering target are derived from zinc atoms in zinc oxide and the metal zinc powder. Tin atoms contained in the sputtering target are derived from tin atoms in tin oxide and the metal tin powder.

When an Sn-rich ZTO having high Sn content is deposited as the second metal oxide layer 22, the adhesion between the metal layer 30 and the metal oxide layer 22 is enhanced to suppress deterioration of the metal layer, and thus the durability of the infrared reflecting substrate tends to be improved. Therefore, the content of Sn in the sputtering target is preferably 40 atom% or more, more preferably 50 atom% or more, and further preferably 60 atom% or more with respect to 100 atom% as a total of Sn and Zn. Although an Sn-rich ZTO, in general, tends to have low electrical conductivity, the electrical conductivity is improved when a target obtained by sintering a metal oxide and a metal powder as described above is used, so that the Sn-rich ZTO can be deposited by DC sputtering with a high deposition rate.

The sputtering target used for the deposition of the second metal oxide layer 22 may contain metals such as Ti, Zr, Hf, Nb, Al, Ga, In and Tl, or metal oxides thereof in addition to zinc, tin and oxides thereof. An increase in the content of a metal atom other than zinc and tin may cause a reduction of the adhesion to the metal layer. Therefore, the total of the contents of zinc atoms and tin atoms in the sputtering target used for deposition of the metal oxide is preferably 97 atom% or more, and more preferably 99 atom% or more with respect to 100 atom% as a total of metals in the sputtering target.

In the sputtering deposition of the second metal oxide layer, it is preferred that at first, inside of the sputtering chamber is evacuated to bring the inside of sputtering apparatus into an atmosphere in which impurities such as water and organic gas generated from the substrate are removed. After the evacuation, sputtering deposition is performed while introducing an inert gas such as Ar, and oxygen into the sputtering chamber. The amount of oxygen introduced into the deposition chamber in the second metal oxide layer forming step is preferably 8 vol% or less, more preferably 5 vol% or less, and further preferably 4 vol% or less with respect to the total flow rate of the introduced gas. When the oxygen introduction amount in sputtering deposition is large, ZTO is completely oxidized, and adhesion between the second metal oxide layer 22 and the metal layer 30 tends to be deteriorated.

On the other hand, when the oxygen introduction amount in sputtering deposition is excessively small, an oxygen deficiency in the metal oxide increases, and the transparency tends to be deteriorated. Therefore, the amount of oxygen introduced into the sputtering chamber in sputtering deposition is preferably 0.1 vol% or more, more preferably 0.5 vol% or more, and further preferably 1 vol% or more with respect to the total flow rate of the introduced gas.

The oxygen introduction amount refers to an amount (vol%) of oxygen introduced into a deposition chamber, in which a target to be used for deposition of the metal oxide layer is placed, with respect to the total amount of the gas introduced into the deposition chamber. When a sputtering deposition apparatus including a plurality of deposition chambers divided by a closure plate is employed, the oxygen introduction amount is calculated based on the amount of gas introduced into each divided deposition chamber.

A substrate temperature during deposition of the second metal oxide layer 22 by sputtering is preferably lower than a heat resistant temperature of the transparent substrate. When the transparent substrate 10 is a resin film substrate, the substrate temperature is preferably, for example, 20°C to 160°C, and more preferably 30°C to 140°C. A power density during sputtering deposition of the second metal oxide layer is preferably, for example, 0.1 W/cm² to 10 W/cm², more preferably 0.5 W/cm² to 7.5 W/cm², and further preferably 1 W/cm² to 6 W/cm². A process pressure during deposition is preferably, for example, 0.01 Pa to 10 Pa, more preferably 0.05 Pa to 5 Pa, and further preferably 0.1 Pa to 1 Pa. When the process pressure is excessively high, a deposition rate tends to decrease, and in contrast, when the pressure is excessively low, discharge tends to be unstable.

The composition (content ratio of metal atoms) of the second metal oxide layer obtained by sputtering deposition reflects the composition of the target. Therefore, a ratio between zinc atoms and tin atoms, respectively, contained in the second metal oxide layer is preferably in the range of Zn : Sn = 10 : 90 to 60 : 40 in terms of an atomic ratio. The ratio between Zn and Sn is more preferably in the range of 15 : 85 to 50 : 50, and further preferably in the range of 20 : 80 to 40 : 60.

When an Sn-rich ZTO having high Sn content is formed as the second metal oxide layer 22, the adhesion between the metal layer 30 and the metal oxide layer 22 is improved. Therefore, deterioration of the metal layer is suppressed and durability of the infrared reflecting substrate tends to increase. From this viewpoint, the content of Sn in the sputtering target is preferably 40 atom% or more, more preferably 50 atom% or more, and further preferably 60 atom% or more with respect to 100 atom% as a total of Sn and Zn. Although an Sn-rich ZTO, in general, tends to have low electrical conductivity, a reductive oxide target obtained by sintering a metal oxide and a metal powder is used as described above so that the electrical conductivity of the target is improved, and thus Sn-rich ZTO can be deposited by DC sputtering in the present invention.

Composition (metal atom content ratio) of the second metal oxide layer formed by the sputtering deposition reflects the composition of the target. Therefore, a ratio between zinc atoms and tin atoms, respectively, contained in the second metal oxide layer is preferably in the range of Zn: Sn = 10 : 90 to 60 : 40 in terms of an atomic ratio. The ratio between Zn and Sn is more preferably in the range of 15 : 85 to 50 : 50, and further preferably in the range of 20 : 80 to 40 : 60.

The thicknesses of the second metal oxide layer 22 is appropriately set in consideration of a material and a thickness of the metal layer and other metal oxide layer so that the visible light reflectance of the infrared reflecting substrate can be reduced to enhance transparency. The thicknesses of the second metal oxide layer may be adjusted, for example, within the range of about 3 nm to 50 nm, preferably within the range of about 5 nm to 30 nm, and more preferably within the range of about 7 nm to 25 nm.

### [Metal layer]

A metal layer 30 is formed on the second metal oxide layer 22 of the substrate-side metal oxide layer 20. The metal layer 30 plays a central role in reflecting infrared rays. A silver layer or a silver alloy layer composed mainly of silver is suitably used as the metal layer 30 from the viewpoint of increasing visible light transmittance of the infrared reflecting substrate. Since silver has a high free electron density, it can realize a high reflectance of near-infrared rays and far-infrared rays, and thus an infrared reflecting substrate with excellent heat shielding effect and heat insulating effect can be obtained.

The content of silver in the metal layer 30 is preferably 85 wt% or more, more preferably 90 wt% or more, further preferably 95 wt% or more. The wavelength selectivity of the transmittance and the reflectance can be enhanced and the visible light transmittance of the infrared reflecting substrate can be increased by increasing the content of silver in the metal layer.

The metal layer 30 may be a silver alloy layer containing metal other than silver. For example, in order to increase the durability of the metal layer, a silver alloy may be used. As the metal added for the purpose of increasing the durability of the metal layer, palladium (Pd), gold (Au), copper (Cu), bismuth (Bi), germanium (Ge), gallium (Ga) and the like are preferred. Among these metals, Pd is most suitably used from the viewpoint of imparting high durability to silver. When an addition amount of Pd or the like is increased, the durability of the metal layer tends to increase. When the metal layer 30 contains metal such as Pd other than silver, the content of the metal is preferably 0.3 wt% or more, more preferably 0.5 wt% or more, further preferably 1 wt % or more, and particularly preferably 2 wt% or more. On the other hand, when the addition amount of Pd or the like is increased and the content of silver is decreased, the visible light transmittance of the infrared reflecting substrate tends to decrease. Therefore, the content of metal other than silver in the metal layer 30 is preferably 15 wt% or less, more preferably 10 wt% or less, further preferably 5 wt% or less.

Although the method for forming the metal layer 30 is not particularly limited, a dry process such as a sputtering method, a vacuum deposition method, a CVD method or an electron-beam deposition method, is preferred. Particularly, in the present invention, it is preferred to form the metal layer by the DC sputtering method in view of improving productivity of the infrared reflecting substrate.

The thickness of the metal layer 30 is appropriately set in consideration of a refractive index of the metal layer, and a refractive index and a thickness of the metal oxide layer so that the infrared reflecting substrate has a low visible light reflectance to enhance transparency. The thickness of the metal layer 30 may be set, for example, within the range of 3 nm to 50 nm.

### [Stacking Configuration on Metal Layer]

As shown in FIG. 1, the infrared reflecting substrate of the present invention may further include other layers on the metal layer 30. From the viewpoint of increasing the visible light transmittance, the infrared reflecting substrate preferably includes a surface-side metal oxide layer 40 on the metal layer 30. Further, from the viewpoint of improving the durability of the infrared reflecting substrate, a transparent resin layer 50 is preferably disposed on the surface-side metal oxide layer 40.

### <Surface-Side Metal Oxide Layer>

When the surface-side metal oxide layer 40 is provided on the metal layer 30, the visible light reflectance at an interface between the surface-side metal oxide layer 40 and the metal layer 30 can be reduced to achieve the high visible light transmittance and the infrared reflectance simultaneously. Further, the surface-side metal oxide layer 40 can also serve as a protective layer for preventing degradation of the metal layer 30.

The surface-side metal oxide layer may be a single-layer or may be a stack of two or more layers. When metal oxide layers having different refractive indices are stacked, the visible light reflectance of the infrared reflecting substrate can be reduced. On the other hand, the surface-side metal oxide layer 40 is preferably a single-layer from the viewpoint of simplifying the stacking configuration of the infrared reflecting substrate to increase productivity. Further, as described later, even when the surface-side metal oxide layer 40 is a single-layer, the visible light reflectance of the infrared reflecting substrate can be reduced to enhance transparency by disposing the transparent resin layer 50 on the surface-side metal oxide layer 40.

From the viewpoint of enhancing the wavelength selectivity of transmission and reflection in the infrared reflecting substrate, the refractive index of the surface-side metal oxide layer 40 is preferably 1.5 or more, more preferably 1.6 or more, and further preferably 1.7 or more. Examples of a material having the above-mentioned refractive index include oxides of metals such as Ti, Zr, Hf, Nb, Zn, Al, Ga, In, Tl and Sn, or composite oxides of these metals. Particularly, in the present invention, as a material of the surface-side metal oxide layer 40, a composite metal oxide containing zinc oxide and tin oxide is preferably used as with the second metal oxide layer 22 on the substrate side.

As described above, the metal oxide containing zinc oxide and tin oxide is excellent in chemical stability (resistance to acid, alkali, chloride ions and the like), the durability of the surface-side metal oxide layer 40 itself is enhanced, and it is possible to suppress the degradation of the metal layer 30 and enhance the durability of the infrared reflecting substrate. Particularly, when the surface-side metal oxide layer 40 has oxygen deficiency, the durability of the infrared reflecting substrate can be further improved due to improved adhesion between the surface-side metal oxide layer 40 and the metal layer 30. Further, when the surface-side metal oxide layer 40 is ZTO having oxygen deficiency, an improvement in durability due to improved adhesion between the metal oxide layer 40 and the transparent resin layer 50 formed thereon, can be expected.

Although the method for depositing the surface-side metal oxide layer is not particularly limited, a DC sputtering method is preferred from the viewpoint of productivity. When a metal oxide layer containing zinc oxide and tin oxide is formed as the surface-side metal oxide layer, a ratio between zinc atoms and tin atoms is preferably within the range of Zn : Sn = 10 : 90 to 60 : 40 in terms of an atomic ratio as with the second metal oxide layer on the substrate side. The ratio Zn : Sn is more preferably 15 : 85 to 50 : 50, and further preferably 20 : 80 to 40 : 60.

In deposition of the surface-side metal oxide layer by sputtering, a reductive oxide target containing zinc atoms and tin atoms and obtained by sintering a metal powder and at least one metal oxide among zinc oxide and tin oxide is preferably used. Further, the oxygen concentration in a gas introduced into the sputtering chamber is preferably 8 vol% or less, more preferably 5 vol% or less, and further preferably 4 vol% or less with respect to the total flow rate of the introduced gas. When the reductive oxide target is used and the surface-side metal oxide layer is deposited at a low oxygen concentration, the surface-side metal oxide layer 40 has excellent adhesion to each of the metal layer 30 and the transparent resin layer 50, and therefore an infrared reflecting substrate having high durability is attained. Further, by decreasing the oxygen introduction amount in deposition of the surface-side metal oxide layer 40, oxidation of the metal layer 30 is suppressed, and the heat insulating properties and heat shielding properties of the infrared reflecting substrate tend to be enhanced.

The thicknesses of the surface-side metal oxide layer 40 can be adjusted within the range of, for example, about 3 nm to 100 nm, and preferably about 5 nm to 80 nm.

### <Transparent Resin Layer>

The transparent resin layer 50 is preferably formed on the surface-side metal oxide layer 40. Since the metal oxide layer 40 formed of an inorganic material and the transparent resin layer 50 formed of an organic material are disposed on the surface of the metal layer 30, a protecting effect on the metal layer 30 is enhanced, and the durability of the infrared reflecting substrate tends to be further improved.

A resin layer (organic material) generally contains C=C bonds, C=O bonds, C-O bonds or aromatic rings, and infrared vibration absorption of a far-infrared ray region of a wavelength of 5 µm to 25 µm is large. The far-infrared rays absorbed at the resin layer is diffused outdoors as heat due to thermal conduction without being reflected at the metal layer. On the other hand, when an amount of far-infrared absorption by the transparent resin layer 50 is low, indoor far-infrared rays transmit the transparent resin layer 50 and the surface-side metal oxide layer 40, and reach the metal layer 30, thereby reflected back to the interior by the metal layer 30 (see FIG. 2). Therefore, the lower absorption of the far-infrared rays by the transparent resin layer 50 is, the higher heat insulating effect by the infrared reflecting substrate becomes.

From the viewpoint of reducing the amount of far-infrared absorption by the transparent resin layer to enhance heat insulating effect of the infrared reflecting substrate, the thickness of the transparent resin layer 50 is preferably 150 nm or less, more preferably 120 nm or less, further preferably 100 nm or less. On the other hand, from the viewpoint of imparting mechanical strength and chemical strength to the transparent resin layer to increase the durability of the infrared reflecting substrate, the thickness of the transparent resin layer 50 is preferably 20 nm or more, more preferably 30 nm or more, further preferably 40 nm or more.

By adjusting the thickness of the transparent resin layer 50 in the above-mentioned range, the heat insulating effect is increased, and further the visible light reflectance of the infrared reflecting substrate is reduced to enhance transparency. In other word, when the thickness of the transparent resin layer 50 is in the above range, the visible light reflectance is reduced by multiplex reflection interference of reflected light on the surface side of the transparent resin layer 50 and reflected light at an interface on the metal oxide layer 40 side, and the transparent resin layer can function as an anti-reflection layer. Therefore, an infrared reflecting substrate having excellent transparency can be attained even when the surface-side metal oxide layer 40 is formed of a single-layer of metal oxide such as ZTO.

In order to reduce the visible light reflectance, an optical thickness (product of a refractive index and a physical thickness) of the transparent resin layer 50 is preferably 50 nm to 150 nm, more preferably 70 nm to 130 nm, and further preferably 80 nm to 120 nm. When the optical thickness of the transparent resin layer is in the above-mentioned range, an anti-reflection effect by the transparent resin layer is enhanced, and in addition to this, the appearance of the infrared reflecting substrate is improved since the optical thickness is smaller than a wavelength range of visible light and therefore "an iris phenomenon" that the surface of the infrared reflecting substrate gives the appearance of a rainbow pattern by the multiplex reflection interference at an interface, is suppressed.

A material of the transparent resin layer 50 preferably has a high visible light transmittance, and excellent mechanical strength and excellent chemical strength. For example, active ray-curable or thermosetting organic resins such as fluorine-based, acryl-based, urethane-based, ester-based, epoxy-based and silicone-based resins; and organic-inorganic hybrid materials in which an organic component is chemically coupled with an inorganic component are preferably used.

It is preferred to introduce a cross-linked structure in the material of the transparent resin layer 50. When the cross-linked structure is formed, mechanical strength and chemical strength of the transparent resin layer are increased, and a function of protecting the metal layer and the metal oxide layer is increased. A cross-linked structure may be introduced in the transparent resin layer by using a crosslinker in formation of the transparent resin layer. Particularly, when an ester compound having an acid group and a polymerizable functional group in the same molecule is used as the crosslinker, mechanical strength or chemical strength of the transparent resin layer tends to be further increased. Examples of the ester compound having an acid group and a polymerizable functional group in a molecule include esters of polybasic acids such as phosphoric acid, sulfuric acid, oxalic acid, succinic acid, phthalic acid, fumaric acid and maleic acid; with a compound having, in a molecule, a hydroxyl group and a polymerizable functional group such as ethylenic unsaturated groups, silanol groups or epoxy groups. Although the polymerizable ester compound may be a polyhydric ester such as diester or triester, it is preferred that at least one acid group of a polybasic acid is not esterified.

From the viewpoint of enhancing mechanical strength and chemical strength of the transparent resin layer 50, the above polymerizable ester compound preferably contains a (meth)acryloyl group as the polymerizable functional group. Further, from the viewpoint of facilitating introduction of the cross-linked structure, the above polymerizable ester compound may have a plurality of polymerizable functional groups in the molecule.

Among the above polymerizable ester compound, an ester compound of phosphoric acid and an organic acid having a polymerizable functional group is preferred to increase the adhesion between the transparent resin layer and the metal oxide layer. It is estimated that an improvement of the adhesion between the transparent resin layer and the metal oxide layer is derived from the fact that an acid group in the polymerizable ester compound exhibits high compatibility with a metal oxide, and in particular, a hydroxyl group of phosphoric acid in the phosphate ester compound has excellent compatibility with a metal oxide layer, thereby improving the adhesion.

As the ester compound of phosphoric acid and an organic acid having a polymerizable functional group, a phosphate monoester compound or a phosphate diester compound represented by the following formula (1), for example, is suitably used. The phosphate monoester may be used in combination with the phosphate diester. 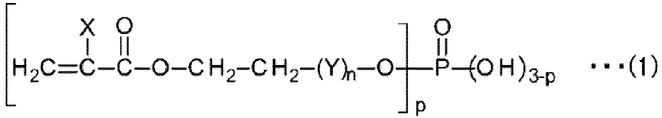 In the above formula, X represents a hydrogen atom or a methyl group, and (Y) represents a -OCO(CH₂)₅- group. n is 0 or 1, p is 1 or 2, and m is an integer of 1 to 6.

Examples of a commercially available product of phosphate ester compound represented by the above formula (1) include KAYAMER series (e.g., "KAYAMER PM-1 ", "KAYAMER PM-21 ", "KAYAMER PM-2") manufactured by Nippon Kayaku Co., Ltd.

An ester compound of a polyfunctional (meth)acrylic compound and a polybasic acid is also preferably used as the above polymerizable ester compound. Examples of the polyfunctional (meth)acrylic compound include pentaerythritol tri(meth)acrylate, dipentaerythritol tri(meth)acrylate, dipentaerythritol tetra(meth)acrylate, dipentaerythritol hexa(meth)acrylate, and the like. An ester compound of a polyfunctional (meth)acrylic compound and a polybasic acid is obtained by esterifying these polyfunctional (meth)acrylic compounds and anhydrides (succinic anhydride, maleic anhydrate, phthalic anhydride etc.) of the polybasic acid.

Examples of commercially available products of the ester compound of a polyfunctional (meth)acrylic compound and a polybasic acid include "LIGHT ACRYLATE DPE6A-MS" (succinic acid modified dipentaerythritol penta(meth)acrylate), "LIGHT ACRYLATE PE3A-MS" (succinic acid modified pentaerythritol triacrylate), "LIGHT ACRYLATE DPE6A-MP" (phthalic acid modified dipentaerythritol pentaacrylate), "LIGHT ACRYLATE PE3A-MP" (phthalic acid modified pentaerythritol triacrylate), and the like.

When the transparent resin layer includes the crosslinked structure derived from the above ester compound, the content of the crosslinked structure in the transparent resin layer is preferably 1 to 40 wt%, more preferably 1.5 to 30 wt%, further preferably 2 to 20 wt%, and particularly preferably 2.5 to 17.5 wt%. When the content of the crosslinked structure derived from the ester compound is excessively low, the effect of improving the strength or the adhesion may not be adequately achieved. On the other hand, when the content of the crosslinked structure derived from the ester compound is excessively high, a curing rate during formation of the transparent resin layer may be low, resulting in a reduction of the hardness of the layer, or slip properties of the surface of the transparent resin layer may be deteriorated, resulting in a reduction of abrasion-resistance. The content of the structure derived from the ester compound in the transparent resin layer can be set to a desired range by adjusting the content of the above ester compound in a composition in formation of the transparent resin layer.

The method for forming the transparent resin layer 50 is not particularly limited. The transparent resin layer is formed by, for example, dissolving in a solvent an organic resin, or a curable monomer or an oligomer of an organic resin, and a crosslinker such as the above-mentioned ester compound as necessary, to prepare a solution; applying the solution onto the metal oxide layer 40; removing the solvent by evaporation; and curing the rest by ultraviolet or electron irradiation or addition of heat energy.

Besides the above-mentioned organic materials and crosslinkers, the material of the transparent resin layer 50 may include additives such as coupling agents (silane coupling agent, titanium coupling agent, etc.), leveling agents, ultraviolet absorbers, antioxidants, heat stabilizers, lubricants, plasticizers, coloring inhibitors, flame retarders and antistatic agents. The contents of these additives can be appropriately adjusted to an extent which does not impair the object of the present invention.

As described above, the adhesion between the layers is increased by forming the surface-side metal oxide layer 40 and the transparent resin layer 50 on the metal layer 30. In addition, the visible light anti-reflection effect may be imparted by adjusting a thickness of the transparent resin layer 50, an infrared reflecting substrate having a high visible light transmittance and excellent durability is obtained even when the surface-side metal oxide layer 40 on the metal layer 30 is a single-layer.

### [Adhesive layer]

A surface opposite to the metal oxide layer 20-forming surface of the transparent substrate 10 may be provided with an adhesive layer or the like to be used for bonding the infrared reflecting substrate to a window glass or the like (see FIG. 2). As the adhesive layer 60, an adhesive having a high visible light transmittance and a small difference in refractive index with the transparent substrate 10 is suitably used. For example, an acryl-based pressure sensitive adhesive is suitable as a material of the adhesive layer provided for the transparent substrate, since it has excellent optical transparency, exhibits appropriate wettability, cohesive property, and adhesion properties, and is excellent in weatherability and heat resistance.

The adhesive layer preferably has a high visible light transmittance and low ultraviolet transmittance. The degradation of the metal layer caused by ultraviolet rays of the sunlight or the like can be suppressed by reducing the ultraviolet transmittance of the adhesive layer. From the viewpoint of reducing the ultraviolet transmittance of the adhesive layer, the adhesive layer preferably contains an ultraviolet absorber. The degradation of the metal layer caused by ultraviolet rays from the outdoors can also be suppressed by using a transparent film substrate containing an ultraviolet absorber. An exposed surface of the adhesive layer is preferably temporarily attached with a separator to be covered for the purpose of preventing the contamination of the exposed surface until the infrared reflecting substrate is put into practical use. This can prevent the contamination of the exposed surface of the adhesive layer due to contact with external during usual handling.

### [Usage]

The infrared reflecting substrate of the present invention can be used for windows of buildings, vehicles or the like, transparent cases for botanical companions or the like, or showcases of freezing or cold storage. When the transparent substrate 10 is a rigid substrate such as glass, the infrared reflecting substrate can be used as a window glass as is. When the transparent substrate 10 is a flexible substrate such as a film substrate, the infrared reflecting substrate is preferably bonded to a window glass or the like to be used.

FIG. 2 is a schematic cross-sectional view showing a usage example of the infrared reflecting substrate. In this usage example, a transparent substrate 10 side of the infrared reflecting substrate 100 is bonded to a window 90 with an appropriate adhesive layer 60 interposed therebetween and the infrared reflecting substrate 100 is arranged on an interior side of a window 90 of buildings or automobiles to be used. In this usage example, a transparent resin layer 50 is arranged on an interior side of the window. Particularly, when the transparent substrate 10 is a resin film substrate, it is preferred that the transparent resin layer 50 is arranged on an interior side in order to enhance indoor heat insulating properties, since the amount of far-infrared absorption by the resin film is large.

As schematically shown in FIG. 2, the infrared reflecting substrate 100 transmits visible light (VIS) from the outdoors to introduce the light to the interior, and reflects near-infrared rays (NIR) from the outdoors at the metal layer 30. Since heat flow from the outdoors to the interior resulting from sunlight or the like is suppressed (heat shielding effect is exerted) by the reflection of near-infrared rays, efficiency of the air conditioning in summer can be increased. Moreover, since the metal layer 30 reflects indoor far-infrared rays (FIR) emitted from a heating appliance 80 etc., a heat insulating effect is exerted and efficiency of heating in winter can be increased.

### EXAMPLE

The present invention will be described more specifically below by showing examples, but the present invention is not limited to these examples.

### [Measuring Methods]

### <Thickness of Each Layer>

A thickness of each layer formed on a transparent film substrate was determined by machining a sample by a focused ion beam (FIB) method using a focused ion beam machining observation device (manufactured by Hitachi, Ltd., trade name "FB-2100"), and observing a cross-section of the sample using a field emission transmission electron microscope (manufactured by Hitachi, Ltd., trade name "HF-2000").

### <Visible Light Transmittance and Reflectance>

Each of the visible light transmittance and reflectance was measured by using a spectral photometer (trade name "U-4100" manufactured by Hitachi High-Technologies Corporation). The transmittance was determined according to JIS A 5759-2008 (Adhesive films for glazings). The reflectance was determined by allowing light to enter at an incident angle of 5° from the surface on a transparent film substrate of the sample for measurement, and calculating an average 5° absolute reflectance in a wavelength range of 400 nm to 800 nm (visible light reflectance).

### <Normal Emissivity>

Infrared rays were irradiated from the transparent resin layer side using a Fourier transform infrared spectrophotometer (FT-IR) (manufactured by Varian Inc.) equipped with angle-variable accessories, and the normal reflectance of infrared rays in a wavelength range of 5 µm to 25 µm was measured, and then the normal emissivity was determined according to JIS R 3106-2008 (Testing method on transmittance, reflectance and emittance of flat glasses and evaluation of solar heat gain coefficient).

### <Salt Water Resistance Test>

A surface on a transparent film substrate side of an infrared reflecting substrate was bonded to a glass plate with a size of 3 cm x 3 cm with a pressure sensitive adhesive layer having a thickness of 25 µm interposed therebetween to form a sample to be used for a test. This sample was immersed in a 5 wt% aqueous solution of sodium chloride, a container containing the sample and the aqueous solution of sodium chloride was placed in a drier at 50°C, and changes in emissivity and changes in appearance were checked 5 days later and 10 days later and rated according the following criteria.
A: After 10 days immersion, there was no change in the appearance and change in the emissivity was 0.02 or less
B: After 5 days immersion, there is no change in the appearance and change in the emissivity is 0.02 or less, but after 10 days immersion, change in the appearance was found
C: After 5 days immersion, change in the appearance was found, but change in the emissivity was 0.02 or less
D: After 5 days immersion, change in the appearance was found, and change in the emissivity was 0.02 or more

### [Example 1]

### (Formation of Hard Coat Layer on Substrate)

An acryl-based ultraviolet-curable hard coat layer (OPSTAR Z7540, manufactured by JSR Corporation) was formed in a thickness of 2 µm on one surface of a polyethylene terephthalate (PET) film (manufactured by Toray Industries Inc., trade name "Lumirror U48", visible light transmittance 93%) having a thickness of 50 µm. Specifically, a hard coat solution was applied with a gravure coater, dried at 80°C, and irradiated with ultraviolet rays of accumulated light quantity of 200 mJ/cm² by an ultra-high pressure mercury lamp to be cured.

### <Formation of Metal Oxide Layer and Metal Layer>

Using a roll-to-roll sputtering apparatus, a niobium oxide layer having a thickness of 17.5 nm, a substrate-side zinc-tin oxide (ZTO) layer having a thickness of 15 nm, a metal layer made of an Ag-Pd alloy and having a thickness of 16 nm, and a surface-side zinc-tin oxide layer having a thickness of 22.5 nm were sequentially formed the hard coat layer of the PET film substrate by a DC magnetron sputtering method.

As the sputtering target, a target (NBO Target) obtained by sintering niobium oxide and a metal niobium powder was used for formation of the niobium oxide layer. The amount of gas introduced into the sputtering chamber in deposition of the niobium oxide layer was set so that a volume ratio between Ar and O₂ was 85 : 15. A refractive index of a niobium oxide layer formed on a PET substrate in the same condition as in the above condition was 2.33.

A target obtained by sintering composition consisting of zinc oxide, tin oxide and a metal zinc powder at a weight ratio of 8.5 : 83 : 8.5 was used for forming the substrate-side and the surface-side ZTO layers, and sputtering was performed under conditions of a power density: 2.67 W/cm², a process pressure: 0.4 Pa, and a substrate temperature: 80°C. In this case, the amount of gas introduced into the sputtering chamber was adjusted so that a ratio between Ar and O₂ is 98 : 2 (volume ratio).

A metal target containing silver and palladium in a weight ratio of 96.4 : 3.6 was used for forming the Ag-Pd metal layer.

### (Formation of Transparent Resin Layer)

A fluorine-based hard coat solution (produced by JSR Corporation, OPSTAR JUA204) was applied onto a surface-side ZTO layer by a gravure coater, dried at 60°C for 1 minute, and irradiated with ultraviolet rays of accumulated light quantity of 400 mJ/cm² by an ultra high pressure mercury lamp in a nitrogen atmosphere to form a fluorine-based hard coat layer having a thickness of 60 nm.

### [Example 2]

An infrared reflecting substrate was prepared in the same manner as in Example 1 except for forming a titanium oxide layer having a thickness of 15 nm in place of the niobium oxide layer as the substrate-side high-refractive index metal oxide layer. As the sputtering target, a target obtained by sintering titanium oxide and a metal titanium powder (manufactured by AGC Ceramics Co., Ltd., TXO Target) was used for formation of the titanium oxide layer. A refractive index of a titanium oxide layer formed on a PET substrate in the same condition as in the above condition was 2.34.

### [Example 3]

An infrared reflecting substrate was prepared in the same manner as in Example 1 except that the thickness of the Ag-Pd metal layer was changed to 11 nm.

### [Comparative Example 1]

In Comparative Example 1, a niobium oxide layer was not formed, and a zinc-tin oxide layer having a thickness of 30 nm was formed on a PET film substrate, and a metal layer made of an Ag-Pd alloy and having a thickness of 15 nm and a zinc-tin oxide layer having a thickness of 22.5 nm were sequentially formed thereon. Further, in Comparative Example 1, the amount of gas introduced into the sputtering chamber in deposition of the substrate-side zinc-tin oxide layer was changed so that a volume ratio between Ar and O₂ was 90 : 10. An infrared reflecting substrate was prepared in the same manner as in Example 1 except for the above changes.

### [Comparative Example 2]

In Comparative Example 2, a niobium oxide layer having a thickness of 32 nm was formed on a PET film substrate, a metal layer made of an Ag-Pd alloy and having a thickness of 16 nm was formed thereon without forming the substrate-side zinc-tin oxide layer. After formation of the metal layer, an infrared reflecting substrate was prepared in the same manner as in Example 1.

### [Comparative Example 3]

The amount of gas introduced into the sputtering chamber in deposition of the substrate-side zinc-tin oxide layer was changed so that a volume ratio between Ar and O₂ was 90 : 10, and the thickness of the Ag-Pd alloy layer was changed to 15 nm. An infrared reflecting substrate was prepared in the same manner as in Example 2 except for the above changes.

### [Comparative Example 4]

In Comparative Example 4, a titanium oxide layer having a thickness of 30 nm was formed on a PET film substrate, and a metal layer made of an Ag-Pd alloy and having a thickness of 15 nm was formed thereon. A surface-side titanium oxide layer having a thickness of 30 nm was further formed on the Ag-Pd metal layer. The formation of both of the substrate-side titanium oxide layer and the surface-side titanium oxide layer was performed in the same conditions as in the formation of the titanium oxide layer in Example 2. In Comparative Example 4, the transparent resin layer was not formed.

### [Reference Examples 1, 2]

Infrared reflecting substrates were prepared in the same manner as in Example 1 except that the thicknesses of the transparent resin layers were respectively changed as shown in Table 1.

### [Evaluation]

Stacking configurations and evaluation results of the infrared reflecting substrates of each of Examples and Comparative Examples described above are shown in Table 1. In the layer configuration shown in Table 1, a value in parentheses represents a thickness of each layer, and a value in square brackets of ZTO substrate-side metal oxide layer represents an oxygen concentration in gas introduced in sputtering deposition. In the case where the oxygen concentration in introduced gas during ZTO deposition is not described, an oxygen concentration was 2 vol%.

**[Table 1]**

| | substrate-side metal oxide layer | | metal layer | surface-side metal oxide layer | protective layer thickness | visible light transmittance (%) | visible light reflectance (%) | normal emissivity (%) | salt water resistance |
|---|---|---|---|---|---|---|---|---|---|
| Example 1 | Nb₂ O₅ (17.5 nm) | ZTO (15nm) | Ag:Pd=9 6.4:3.6 (16nm) | ZTO (22.5 nm) | 60nm | 70.2 | 10.1 | 0.06 | A |
| Example 2 | TiO₂ (15nm) | ZTO (15nm) | Ag:Pd=9 6.4:3.6 (16nm) | ZTO (22.5 nm) | 60nm | 69.5 | 10.7 | 0.07 | A |
| Example 3 | Nb₂ O₅ (17.5 nm) | ZTO (15nm) | Ag:Pd=9 6.4:3.6 (11 nm) | ZTO (22.5 nm) | 60nm | 78.3 | 5.1 | 0.10 | A |
| Comparative Example 1 | ZTO [10vol%] (30nm) | | Ag:Pd=9 6.4:3.6 (16nm)) | ZTO (22.5 nm) | 60nm | 67.8 | 14.5 | 0.06 | B |
| Comparative Example 2 | Nb₂O₅ (32nm) | | Ag:Pd=9 6.4:3.6 (16nm) | ZTO (22.5 nm) | 60nm | 69.9 | 9.8 | 0.07 | D |
| Comparative Example 3 | TiO₂ (15nm) | ZTO [10v ol%] (15nm) | Ag:Pd=9 6.4:3.6 (15nm) | ZTO (22.5 nm) | 60nm | 72.1 | 10.2 | 0.07 | C |
| Comparative Example 4 | TiO₂ (30nm) | | Ag:Pd=9 6.4:3.6 (15nm) | T₁O₂ (30n m) | - | - | | | |
| Reference Example 1 | Nb₂ O₅ (15nm) | ZTO (15nm) | Ag:Pd=9 6.4:3.6 (15nm) | ZTO (22.5 nm) | 10nm | 64.5 | 9.1 | 0.07 | D |
| Reference Example 2 | Nb₂ O₅ (15nm) | ZTO (15nm) | Ag:Pd=9 6.4:3.6 (15nm) | ZTO (22.5 nm) | 200nm | 62.8 | 10.8 | 0.08 | A |

All of the infrared reflecting films of Examples 1 to 3 in which a high-refractive index metal oxide layer and low oxygen content ZTO were sequentially formed on the PET film substrate as the substrate-side metal oxide layer, had a high visible light transmittance and good salt water resistance. In Example 3 in which the thickness of the metal layer was 11 nm, the visible light transmittance was significantly improved because of a reduction in reflectance, although a normal emissivity was slightly increased compared with Example 1 in which the thickness of the metal layer was 16 nm.

In Comparative Example 3 in which the ZTO layer on the substrate side was formed at oxygen introduction amount of 10 vol%, the salt water resistance was lower than Example 2. In Comparative Example 3, although the visible light reflectance of the infrared reflecting film was approximately equal to Example 2, the visible light transmittance was improved. The reason for this is supposed that since the oxygen introduction amount in deposition of the substrate-side ZTO layer was large, the oxygen amount in ZTO reached the stoichiometric composition, and light absorption by the ZTO was reduced.

In Comparative Example 1 in which only the ZTO layer was formed as the substrate-side metal oxide layer and the high-refractive index metal oxide layer was not formed, the visible light reflectance was significantly increased compared with Example 1. Therefore, in Comparative Example 1, the visible light transmittance was lower than that of Example 1, in spite of that the oxygen introduction amount in deposition of the substrate-side ZTO layer was larger than that of Example 1 and thereby reduced light absorption of ZTO. On the other hand, in Comparative Example 2 in which only the high-refractive index metal oxide layer was formed as the substrate-side metal oxide layer and the ZTO layer was not formed on the substrate side, the visible light transmittance was almost equal to Example 1, but the durability was significantly deteriorated.

In Comparative Example 4 in which the titanium oxide layers were formed as the substrate-side metal oxide layer and the surface-side metal oxide layer, the metal layer became black after deposition of the titanium oxide layer on the surface side. The reason for this is supposed that the metal layer serving as an underlay was deteriorated by oxidation in deposition of the titanium oxide layer on the metal layer. Comparing Example 1 with Reference Examples 1 and 2, it is found that the visible light transmittance and durability can be improved by adjusting the thickness of the transparent resin layer to be formed on an outermost surface of the infrared reflecting film. In Reference Example 2 in which a thickness of the transparent protective layer was 200 nm, an appearance was deteriorated due to an iris phenomenon.

From the results described above, it is found that an infrared reflecting substrate having a high visible light transmittance and excellent durability is obtained when a high-refractive index metal oxide layer such as titanium oxide or niobium oxide and a ZTO having an oxygen content less than that of the stoichiometric composition are sequentially formed as a substrate-side metal oxide layer, and a metal layer is formed thereon.

### DESCRIPTION OF REFERENCE CHARACTERS

- 100:: infrared reflecting substrate
- 10:: transparent substrate
- 20:: substrate-side metal oxide layer
- 21: first metal oxide layer
- 22:: second metal oxide layer
- 30:: metal layer
- 40:: surface-side metal oxide layer
- 50:: transparent resin layer
- 60:: adhesive layer

## Claims

1. An infrared reflecting substrate comprising: a transparent substrate; and a first metal oxide layer, a second metal oxide layer and a metal layer disposed in this order on the transparent substrate, wherein
the first metal oxide layer has a refractive index of 2.2 or more,
the second metal oxide layer is formed of a metal oxide that contains tin oxide and zinc oxide and an oxygen content of the metal oxide is less than the stoichiometric composition, and
the second metal oxide layer and the metal layer are in direct contact with each other.

2. The infrared reflecting substrate according to claim 1, wherein the first metal oxide layer is formed of an oxide of one or more metals selected from the group consisting of Ti, Nb, Ta, Mo, W and Zr.

3. The infrared reflecting substrate according to claim 1 or 2, further comprising a surface-side metal oxide layer on the metal layer on a side opposite to a substrate-side.

4. The infrared reflecting substrate according to claim 3, wherein the surface-side metal oxide layer is formed of a metal oxide that contains tin oxide and zinc oxide.

5. The infrared reflecting substrate according to claim 3 or 4, wherein the surface-side metal oxide layer is in direct contact with the metal layer.

6. The infrared reflecting substrate according to any one of claims 3 to 5, further comprising a transparent resin layer on the surface-side metal oxide layer.

7. The infrared reflecting substrate according to claim 6, wherein the transparent resin layer is in direct contact with the surface-side metal oxide layer.

8. The infrared reflecting substrate according to claim 6 or 7, wherein the transparent resin layer has a thickness of 20 nm to 150 nm.

9. The infrared reflecting substrate according to any one of claims 1 to 8, wherein the transparent substrate is a flexible transparent film.

10. A method for producing an infrared reflecting substrate, the infrared reflecting substrate comprising a first metal oxide layer, a second metal oxide layer and a metal layer in this order on a transparent substrate,
the first metal oxide layer having a refractive index of 2.2 or more, the second metal oxide layer being formed of a metal oxide that contains tin oxide and zinc oxide,
the method comprising in the order:
first metal oxide layer forming step of depositing a first metal oxide layer on a transparent substrate;
second metal oxide layer forming step of depositing a second metal oxide layer on the first metal oxide layer by a DC sputtering method; and
metal layer forming step of depositing a metal layer immediately on the second metal oxide layer, wherein
in the second metal oxide layer forming step,
a sputtering target containing zinc atoms and tin atoms and obtained by sintering a metal powder and at least one metal oxide among zinc oxide and tin oxide is used, and
an inert gas and oxygen are introduced into a sputtering chamber, and an oxygen concentration in the gas introduced into the sputtering chamber is 8 vol% or less.

11. The method for producing an infrared reflecting substrate according to claim 10, further comprising a surface-side metal oxide layer forming step of depositing a surface-side metal oxide layer on the metal layer by a DC sputtering method, the surface-side metal oxide layer being formed of a metal oxide that contains tin oxide and zinc oxide.

12. The method for producing an infrared reflecting substrate according to claim 11, wherein in the surface-side metal oxide layer forming step,
the surface-side metal oxide layer is deposited by a DC sputtering method with using a sputtering target containing zinc atoms and tin atoms and obtained by sintering a metal powder and at least one metal oxide among zinc oxide and tin oxide.

13. The method for producing an infrared reflecting substrate according to claim 11 or 12, further comprising a transparent resin layer forming step of forming a transparent resin layer on the surface-side metal oxide layer.
